# EUROPEAN PATENT APPLICATION

(11) **EP 1 901 307 A2**
(43) Date of publication of application: **19.03.2008**
(21) Application number: 07017099.8
(22) Date of filing: 31.08.2007
(51) Int. Cl.: G11C 16/02

(54) **Resistive memory having shunted memory cells**

(30) Priority: 14.09.2006 US 521527
(71) Applicant: Qimonda North America Corp., Cary, NC 27513 (US)
(72) Inventor: Happ, Thomas, Dr., 01109 Dresden (DE); Philipp, Jan Boris, 81673 München (DE); Nirschl, Thomas, Essex Junction, VT 05452 (US)
(74) Representative: Jehle, Volker Armin

(57) **Abstract**

A memory includes a bit line, a plurality of resistive memory cells coupled to the bit line, and a resistor. The resistor is coupled to the bit line to form a current divider with a selected memory cell during a read operation.

## Description

### Background

One type of memory is resistive memory. Resistive memory utilizes the resistance value of a memory element to store one or more bits of data. For example, a memory element programmed to have a high resistance value may represent a logic "1" data bit value, and a memory element programmed to have a low resistance value may represent a logic "0" data bit value. The resistance value of the memory element is switched electrically by applying a voltage pulse or a current pulse to the memory element. One type of resistive memory is phase change memory. Phase change memory uses a phase change material for the resistive memory element.

Phase change memories are based on phase change materials that exhibit at least two different states. Phase change material may be used in memory cells to store bits of data. The states of phase change material may be referred to as amorphous and crystalline states. The states may be distinguished because the amorphous state generally exhibits higher resistivity than does the crystalline state. Generally, the amorphous state involves a more disordered atomic structure, while the crystalline state involves a more ordered lattice. Some phase change materials exhibit more than one crystalline state, e.g. a face-centered cubic (FCC) state and a hexagonal closest packing (HCP) state. These two crystalline states have different resistivities and may be used to store bits of data. In the following description, the amorphous state generally refers to the state having the higher resistivity, and the crystalline state generally refers to the state having the lower resistivity.

Phase change in the phase change materials may be induced reversibly. In this way, the memory may change from the amorphous state to the crystalline state and from the crystalline state to the amorphous state in response to temperature changes. The temperature changes to the phase change material may be achieved by driving current through the phase change material itself, or by driving current through a resistive heater adjacent the phase change material. With both of these methods, controllable heating of the phase change material causes controllable phase change within the phase change material.

A phase change memory including a memory array having a plurality of memory cells that are made of phase change material may be programmed to store data utilizing the memory states of the phase change material. One way to read and write data in such a phase change memory device is to control a current and/or a voltage pulse that is applied to the phase change material. The level of current and/or voltage generally corresponds to the temperature induced within the phase change material in each memory cell.

To achieve higher density phase change memories, a phase change memory cell can store multiple bits of data. Multi-bit storage in a phase change memory cell can be achieved by programming the phase change material to have intermediate resistance values or states. If the phase change memory cell is programmed to one of three different resistance levels, 1.5 bits of data per cell can be stored. If the phase change memory cell is programmed to one of four different resistance levels, two bits of data per cell can be stored, and so on.

Typically, there is a wide distribution of resistance values of a phase change memory cell in the crystalline state and in the amorphous state. The time to read the value of a phase change memory cell may be significantly long due to the high resistance of the amorphous state of the phase change material. This significantly long read time leads to slow overall memory operation.

For these and other reasons, there is a need for the present invention.

### Summary

One embodiment of the present invention provides a memory. The memory includes a bit line, a plurality of resistive memory cells coupled to the bit line, and a resistor. The resistor is coupled to the bit line to form a current divider with a selected memory cell during a read operation.

### Brief Description of the Drawings

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Figure 1 is a diagram illustrating one embodiment of a memory device.
Figure 2 is a diagram illustrating one embodiment of a single bit line and a sense amplifier in the memory device.
Figure 3 is a chart illustrating one embodiment of resistance distributions for memory cells in set and reset states.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

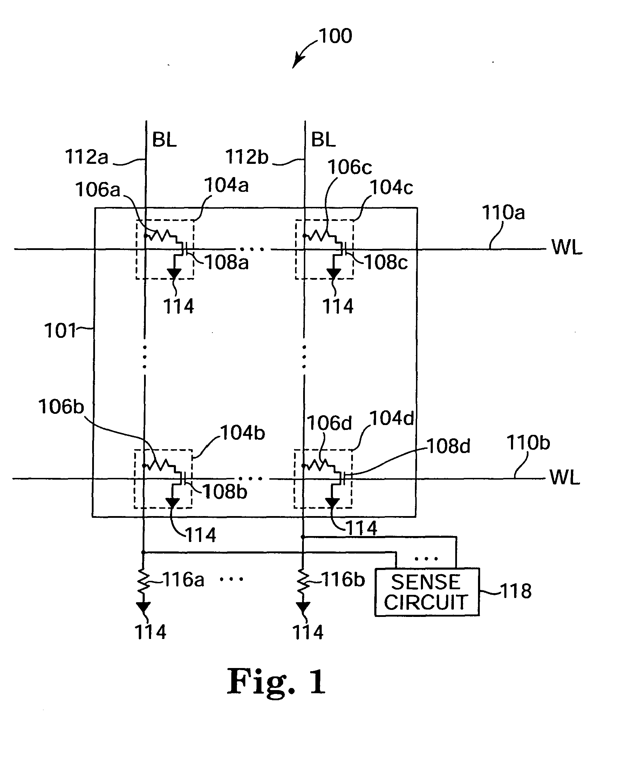

Figure 1 is a diagram illustrating one embodiment of a memory device 100. Memory device 100 includes an array of phase change memory cells 101, a plurality of shunt resistors 116a-116b (collectively referred to as shunt resistors 116), and a sense circuit 118. Memory array 101 includes a plurality of phase change memory cells 104a-104d (collectively referred to as phase change memory cells 104), a plurality of bit lines (BLs) 112a-112b (collectively referred to as bit lines 112), and a plurality of word lines (WLs) 110a-110b (collectively referred to as word lines 110).

Phase change memory cells 104 are shunted by shunt resistors 116. During a read operation of a phase change memory cell 104, if the memory cell is in a crystalline state, more current flows through the memory cell than through the shunt resistor. If the memory cell is in an amorphous state, more current flows through the shunt resistor than through the memory cell. Sense circuit 118 senses the state of the memory cell based on the current through the shunt resistor. In this way, the time for sense circuit 118 to sense the state of a memory cell 104 is reduced in comparison to a memory array that does not include shunt resistors 116.

As used herein, the term "electrically coupled" is not meant to mean that the elements must be directly coupled together and intervening elements may be provided between the "electrically coupled" elements.

Each phase change memory cell 104 is electrically coupled to a word line 110, a bit line 112, and common or ground 114. For example, phase change memory cell 104a is electrically coupled to bit line 112a, word line 110a, and common or ground 114, and phase change memory cell 104b is electrically coupled to bit line 112a, word line 110b, and common or ground 114. Phase change memory cell 104c is electrically coupled to bit line 112b, word line 110a, and common or ground 114, and phase change memory cell 104d is electrically coupled to bit line 112b, word line 110b, and common or ground 114. Each bit line 112 is electrically coupled to a shunt resistor 116 and sense circuit 118. Each shunt resistor 116 is also electrically coupled to common or ground 114.

Each phase change memory cell 104 includes a phase change element 106 and a transistor 108. While transistor 108 is a field-effect transistor (FET) in the illustrated embodiment, in other embodiments, transistor 108 can be other suitable devices such as a bipolar transistor or a 3D transistor structure. In other embodiments, a diode-like structure may be used in place of transistor 108. Phase change memory cell 104a includes phase change element 106a and transistor 108a. One side of phase change element 106a is electrically coupled to bit line 112a, and the other side of phase change element 106a is electrically coupled to one side of the source-drain path of transistor 108a. The other side of the source-drain path of transistor 108a is electrically coupled to common or ground 114. The gate of transistor 108a is electrically coupled to word line 110a.

Phase change memory cell 104b includes phase change element 106b and transistor 108b. One side of phase change element 106b is electrically coupled to bit line 112a, and the other side of phase change element 106b is electrically coupled to one side of the source-drain path of transistor 108b. The other side of the source-drain path of transistor 108b is electrically coupled to common or ground 114. The gate of transistor 108b is electrically coupled to word line 110b.

Phase change memory cell 104c includes phase change element 106c and transistor 108c. One side of phase change element 106c is electrically coupled to bit line 112b, and the other side of phase change element 106c is electrically coupled to one side of the source-drain path of transistor 108c. The other side of the source-drain path of transistor 108c is electrically coupled to common or ground 114. The gate of transistor 108c is electrically coupled to word line 110a.

Phase change memory cell 104d includes phase change element 106d and transistor 108d. One side of phase change element 106d is electrically coupled to bit line 112b, and the other side of phase change element 106d is electrically coupled to one side of the source-drain path of transistor 108d. The other side of the source-drain path of transistor 108d is electrically coupled to common or ground 114. The gate of transistor 108d is electrically coupled to word line 110b.

In another embodiment, each phase change element 106 is electrically coupled to common or ground 114 and each transistor 108 is electrically coupled to a bit line 112. For example, for phase change memory cell 104a, one side of phase change element 106a is electrically coupled to common or ground 114. The other side of phase change element 106a is electrically coupled to one side of the source-drain path of transistor 108a. The other side of the source-drain path of transistor 108a is electrically coupled to bit line 112a.

Each phase change element 106 comprises a phase change material that may be made up of a variety of materials in accordance with the present invention. Generally, chalcogenide alloys that contain one or more elements from group VI of the periodic table are useful as such materials. In one embodiment, the phase change material of phase change element 106 is made up of a chalcogenide compound material, such as GeSbTe, SbTe, GeTe or AgInSbTe. In another embodiment, the phase change material is chalcogen free, such as GeSb, GaSb, InSb, or GeGaInSb. In other embodiments, the phase change material is made up of any suitable material including one or more of the elements Ge, Sb, Te, Ga, As, In, Se, and S.

Shunt resistor 116a shunts current from memory cells 104a-104d on bit line 112a, and shunt resistor 116b shunts current from memory cells 104c-104d on bit line 112b. In one embodiment, resistors 116a-116b are linear resistors. In another embodiment, resistors 116a-116b are active devices configured to act as resistors. During a read operation of a selected memory cell 104, more current flows through the selected memory cell 104 than the shunt resistor 116 if the memory cell is in a lower resistance crystalline state. More current, however, flows through the shunt resistor 116 than through the selected memory cell 104 if the selected memory cell 104 is in a higher resistance amorphous state. The resistance values of shunt resistors 116 are selected to be between the lower resistance of the crystalline state and the higher resistance of the amorphous state.

Sense circuit 118 reads the states of memory cells 104a-104d through bit lines 112a-112b based on the current through shunt resistors 116a-116b. In one embodiment, to read the resistance of one of the memory cells 104a-104d sense circuit 118 provides current that flows through one of the memory cells 104a-104d and one of shunt resistors 116a-116b through bit lines 112a-112b and sense circuit 118 reads the voltage across that one of the memory cells 106a-106b and shunt resistors 116a-116b. With a selected memory cell 104a-104d in a crystalline state, sense circuit 118 senses a lower voltage than with the selected memory cell in an amorphous state.

During a set operation of phase change memory cell 104a, a set current or voltage pulse is selectively enabled and sent through bit line 112a to phase change element 106a thereby heating it above its crystallization temperature (but usually below its melting temperature) with word line 110a selected to activate transistor 108a. In this way, phase change element 106a reaches its crystalline state during this set operation. During a reset operation of phase change memory cell 104a, a reset current or voltage pulse is selectively enabled and sent through bit line 112a to phase change element 106a. The reset current or voltage quickly heats phase change element 106a above its melting temperature. After the current or voltage pulse is turned off, the phase change element 106a quickly quench cools into the amorphous state. Phase change memory cells 104b-104d and other phase change memory cells 104 in memory array 100 are set and reset similarly to phase change memory cell 104a using a similar current or voltage pulse.

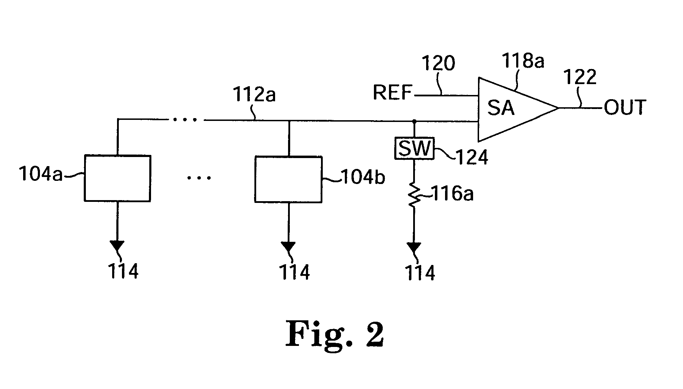

Figure 2 is a diagram illustrating one embodiment of a single bit line 112a and a sense amplifier (SA) 118a in memory device 100. The first side of each phase change memory cell 104a-104b is electrically coupled to a first input of sense amplifier 118a and the first side of an optional switch (SW) 124 through bit line 112a. The second side of optional switch 124 is electrically coupled to the first side of shunt resistor 116a. The second side of each phase change memory cell 104a-104b and the second side of shunt resistor 116a are electrically coupled to common or ground 114. A second input of sense amplifier 118a receives a reference (REF) signal on REF signal path 120. The output of sense amplifier 118a provides the output (OUT) signal on OUT signal path 122. Sense amplifier 118a is part of sense circuit 118.

Optional switch 124 is a transmission gate, transistor, or other suitable switch. Switch 124 is turned on to couple bit line 112a to shunt resistor 116a to pass signals between bit line 112a and shunt resistor 116a. Switch 124 is turned off to block signals from passing between bit line 112a and shunt resistor 116a. In one embodiment, optional switch 124 is part of sense circuit 118. In one embodiment, the bit line quench device acts as a shunt device by controlling the resistance of the quench device to an appropriate value.

Sense amplifier 118a receives the REF signal on REF signal path 120 and the signal on bit line 112a to provide the OUT signal on OUT signal path 122. In response to the signal on bit line 112a having a value greater than the REF signal, sense amplifier 118a outputs a logic high OUT signal on OUT signal path 122. In response to the signal on bit line 112a having a value less than the REF signal, sense amplifier 118a output a logic low OUT signal on OUT signal path 122. In other embodiments, the logic levels of the OUT signal on OUT signal path 122 are reversed.

During a read operation and with switch 124 turned on, a current is applied to bit line 112a and a memory cell 104a-104b is selected. The current is divided between the selected memory cell and shunt resistor 116a based on the state of the phase change element within the selected memory cell. Sense amplifier 118a compares the REF signal to the signal on bit line 112a to provide the OUT signal indicating the state of the selected memory cell. In one embodiment, if the voltage across shunt resistor 116a is greater than a voltage on REF signal path 120, sense amplifier 118a outputs a logic high signal on OUT signal path 122 indicating the selected memory cell is in an amorphous state. In response to the voltage across shunt resistor 116a being less than the voltage on REF signal path 120, sense amplifier 118a outputs a logic low signal on OUT signal path 122 indicating the selected memory cell is in a crystalline state. By shunting the current from memory cells 104a-104b, shunt resistor 116a increases the speed of read operations.

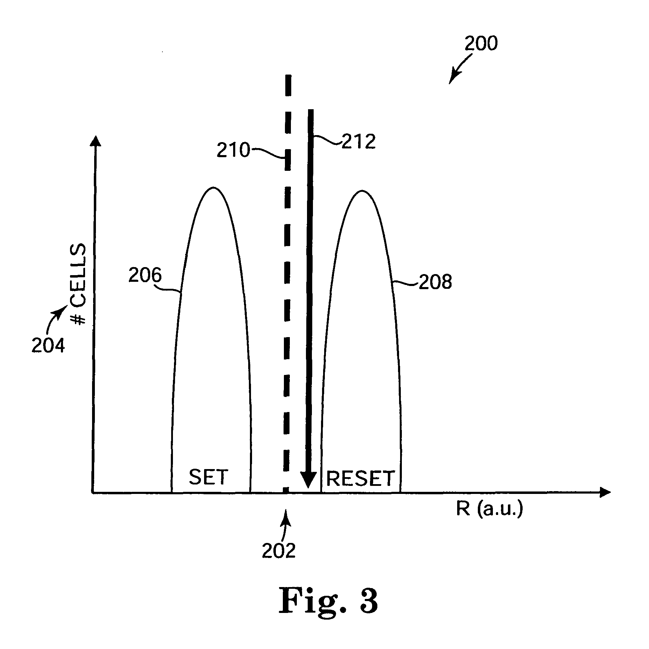

Figure 3 is a chart 200 illustrating one embodiment of resistance distributions for memory cells in SET and RESET states. Chart 200 includes resistance on x-axis 202 and the number of cells on y-axis 204. The resistance distribution for SET phase change memory cells is illustrated at 206, and the resistance distribution for RESET phase change memory cells is illustrated at 208. The REF signal on REF signal path 120 input to sense amplifier 118a is set at a value representing the resistance indicated at 210 between the SET resistance distribution 206 and the RESET resistance distribution 208. Shunt resistors 116a-116b are selected to provide the resistance indicated at 212, which is greater than the value of the REF signal at 210 and less than the lowest value of the RESET resistance distribution 208. Therefore, phase change element resistance values above the shunt resistor value at 212 do not lengthen the time used for read operations.

Embodiments of the present invention provide an array of phase change memory cells including shunt resistors. The shunt resistors are centralized to bit lines or inputs of the sense amplifiers. Hence the memory cells are not altered and each memory cell has the same parallel resistance to simplify the read operation.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A memory comprising:
a bit line;
a plurality of resistive memory cells coupled to the bit line; and
a resistor coupled to the bit line to form a current divider with a selected memory cell during a read operation.

2. The memory cell of claim 1, wherein the resistive memory cells comprise phase change memory cells.

3. The memory of claim 2, wherein each memory cell comprises at least one of Ge, Sb, Te, Ga, As, In, Se, and S.

4. The memory of claim 1, further comprising:
a switch coupled between the bit line and the resistor, the switch for selectively electrically coupling the bit line to the resistor.

5. The memory of claim 1, further comprising:
a sense circuit coupled to the bit line for sensing a state of the selected memory cell based on a current through the resistor.

6. A memory comprising:
a plurality of resistive memory cells;
a resistor coupled in parallel with the memory cells forming a current divider with a selected memory cell; and
a sense circuit for sensing a state of the selected memory cell based on a divided current signal through the resistor and the selected memory cell.

7. The memory of claim 6, wherein the memory cells comprise phase change memory cells.

8. The memory of claim 6, further comprising:
a bit line coupled to the plurality of memory cells and the resistor.

9. The memory of claim 6, wherein the sense circuit comprises a sense amplifier for sensing the state of the selected memory cell and the resistor is coupled to an input of the sense amplifier.

10. The memory of claim 6, wherein the resistor comprises a linear resistor.

11. The memory of claim 6, wherein the resistor comprises an active device acting as a resistor.

12. A memory comprising:
a bit line;
a plurality of resistive memory cells coupled to the bit line; and
means for shunting a current from a selected memory cell during a read operation.

13. The memory cell of claim 12, wherein the resistive memory cells comprise phase change memory cells.

14. The memory of claim 13, wherein each memory cell comprises at least one of Ge, Sb, Te, Ga, As, In, Se, and S.

15. The memory of claim 12, further comprising:
means for selectively electrically coupling the bit line to the means for shunting the current.

16. The memory of claim 12, further comprising:
means for sensing a state of the selected memory cell based on the shunted current.

17. A method for sensing a state of a resistive memory cell, the method comprising:
applying a first current to a bit line coupled to a selected memory cell;
shunting a portion of the first current though a resistor coupled to the bit line; and
sensing a state of the selected memory cell based on the shunted portion of the first current.

18. The method of claim 17, wherein sensing the state of the resistive memory cell comprises sensing the state of a phase change memory cell.

19. The method of claim 18, wherein sensing the state of the memory cell comprises sensing the state of a memory cell comprising at least one of Ge, Sb, Te, Ga, As, In, Se, and S.

20. The method of claim 17, further comprising:
selectively electrically coupling the resistor to the bit line.

21. A method for operating a memory, the method comprising:
applying a first current to a selected memory cell;
dividing the first current to provide a second current indicating a state of the selected memory cell; and
determining the state of the selected memory cell based on the second current.

22. The method of claim 21, wherein applying the first current to the selected memory cell comprises applying the first current to a selected phase change memory cell.

23. The method of claim 21, wherein dividing the first current comprises dividing the first current between the selected memory cell and a shunt resistor.
